# EUROPÄISCHE PATENTSCHRIFT

(11) **EP 0 798 399 B1**
(45) Veröffentlichungstag und Bekanntmachung des Hinweises auf die Patenterteilung: **12.07.2000**
(21) Anmeldenummer: 96120195.1
(22) Anmeldetag: 16.12.1996
(51) Int. Cl.: C23C 14/06, C23C 14/02, C23C 14/14, C23C 14/16

(54) **Verfahren zum Beschichten von metallischen und keramischen substraten**
Method of coating metallic and ceramic substrates
Procédé pour le revêtement de substrats métalliques et céramiques

(30) Priorität: 18.12.1995 DE 19547305
(43) Veröffentlichungstag der Anmeldung: 01.10.1997
(73) Patentinhaber: Hauzer Industries B.V., 5900 AE Venlo (NL)
(72) Erfinder: Münz, Wolf-Dieter, Prof.Dr., Sheffield S7 1SL (GB); Brooks, John Stuart, Prof.Dr., Sheffield S11 9LG (GB); Smith, Ian, Sheffield S7 1SN (GB); Donohue, Lee Adrian, Dr., Sheffield S7 1FG (GB)
(74) Vertreter: Finsterwald, Manfred, Dipl.-Ing., Dipl.-Wirtsch.-Ing.

(56) Entgegenhaltungen:
- EP-A- 0 558 061
- WO-A-93/07306
- FR-A- 2 344 642

## Beschreibung

Die Erfindung betrifft ein Verfahren zum Beschichten von metallischen und keramischen Substraten wie Schneidwerkzeugen oder Umformwerkzeugen und dergleichen mit TiAlN.

Es ist bekannt, daß Titanaluminiumnitrid als Alternative zu hochverschleißfesten TiN-Hartstoffschichten verwendet werden kann. Insbesondere der verbesserte Oxidationswiderstand gegenüber TiN macht dieses Beschichtungsmaterial zum aussichtsreichen Kandiaten für kühlmittelfreie Zerspanung in automatischen Fertigungsstraßen, wie zum Beispiel in der modernen Automobilindustrie. Darüber hinaus zeigen Titan-Aluminiumnitrid-Hartstoffschichten erhöhten Widerstand gegen abrasiven Verschleiß in Gegenwart von Karbiden, was besonders vorteilhaft bei der Bearbeitung von Grauguß und Kaltarbeitsstählen zum Ausdruck kommt.

Titan-Aluminiumnitrid wird heute mit allen bekannten PVD-Hartstoffbeschichtungsverfahren hergestellt, nämlich Kathodenzerstäubung, kathodischer Bogenentladungsverdampfung und Niedervolt-Elektronenstrahlverfahren.

Außerdem sind Kombinationsverfahren bekannt, wie die Kombination des kathodischen Bogenentladungsverdampfungsverfahrens als Ätzquelle im PVD-Prozeß mit dem unbalancierten Magnetron als Beschichtungswerkzeug oder die Kombination entweder des kathodischen Bogenentladungsverdampfungsverfahrens mit der Niedervolt-Elektronenstrahlverdampfung oder mit dem Magnetron während der Beschichtung.

Aus der EP-Patentschrift 0 439 561 ist ein solches Verfahren zur Beschichtung von Substraten bekannt, das auch als ABS-Verfahren bezeichnet wird, bei dem die aufzubringende Schicht durch auf das betreffende Substrat auftreffende kondensierende Teilchen eines mittels einer Gasentladung erzeugten Plasmas hergestellt und sowohl eine Bogenentladungsverdampfung als auch eine Kathodenzerstäubung vorgenommen wird. Wesentlich ist dabei, daß die Bogenentladungsverdampfung nur während einer ersten Beschichtungsphase und die Kathodenzerstäubung während einer auf diese erste Phase folgenden zweiten Beschichtungsphase durchgeführt wird, wobei das Substrat während der Bogenentladungsverdampfung mit Ionen beschossen und dabei die Energie und Ionenstromdichte derart gewählt werden, daß die Substratoberfläche durch Ionenätzung gereinigt und teilweise abgetragen wird.

Bei dem während der Bogenentladungsverdampfung erfolgenden Beschuß des Substrats mit Ionen wird die Ionenenergie und Ionenstromdichte bei diesem Verfahren vorzugsweise derart gewählt, daß eine Verankerung der aufzubauenden Schicht im Substratmaterial bewirkt wird.

Bei der Vorrichtung zur Durchführung dieses Verfahrens ist in einer mit einem Prozeßgas gefüllten Vakuumkammer ein gegenüber der Vakuumkammer elektrisch isolierter Substrathalter, eine mit dem Beschichtungsmaterial belegte, gegenüber der Vakuumkammer ebenfalls elektrisch isolierte Kathode und eine für die Bogenentladung erforderliche Anode vorgesehen. Die Kathode ist wahlweise mit einer Bogenentladungsversorgung oder einer Kathodenzerstäubungsversorgung verbindbar und an derart negative Potentiale schaltbar, daß in einem ersten Stromkreis zwischen der Kathode und der Anode eine Bogenentladung oder in einem zweiten Stromkreis eine Kathodenzerstäubungsentladung entsteht.

Aus der EP 0 459 137 A1 ist eine Vorrichtung zur Beschichtung von Substraten unter Verwendung einer Bogenentladung und einer Kathodenzerstäubung bekannt, welche ein evakuierbares Gefäß aufweist, in dem zumindest ein Target, eine zugehörige Anode sowie ein Substratträger angeordnet und die zugehörigen Strom- und Spannungsversorgungen vorgesehen sind und jedem Target eine Magnetanordnung zugeordnet ist. Die aus einem Mittelpol-Permanentmagneten und diesen mit Abstand umgebenden, entgegengesetzt gepolten Rand-Permanentmagneten bestehende Magnetanordnung ist relativ zum zugehörigen Target derart verschiebbar gelagert, daß im Targetbereich in einer ersten, dem Target benachbarten Position ein eine Kathodenzerstäubung ermöglichendes Magnetfeld und in einer zweiten, bezüglich des Targets beabstandeten Position ein eine Bogenentladung ermöglichendes Magnetfeld erzeugt wird.

Die vorliegende Erfindung befaßt sich mit PVD-Verfahren, die vorzugsweise entweder ausschließlich die kathodische Bogenentladungsverdampfung als Prozeßquelle oder diese in Kombination mit kathodischen Zerstäubungsverfahren (Magnetron, unbalanciertes Magnetron) benutzen.

Ausgangspunkt ist die Beobachtung, daß während des Metall-Ionen-Ätzprozesses der Substrate sogenannte "droplets" auf der Substratoberfläche abgeschieden werden, die sich während der darauffolgenden Beschichtung als Ursache für lokale Wachstumsdefekte erweisen und die zu einer enormen Steigerung der Oberflächenrauhigkeit der Titan-Aluminiumnitrid-Schicht beitragen.

Dies gilt sowohl für den Fall, daß die PVD-Beschichtung nach dem Metallionen-Ätzen mit einem Verfahren fortgesetzt wird, das selbst keine "droplets" erzeugt, wie zum Beispiel beim unbalancierten Magnetron oder aber auch beim reinen kathodischen Bogenentladungsverdampfen, bei dem während der Beschichtung noch zusätzliche "droplet"-Bildung zu beobachten ist und damit eine weitere Erhöhung der Oberflächenrauhigkeit stattfindet.

Wie anhand des Verhaltens von TiAl und Ti als Targetmaterial im kathodischen Bogenentladungsprozeß gezeigt werden kann, ist die Anzahl der beim Metallionen-Ätzen entstehenden "droplets" abhängig von der Schmelztemperatur des Targets. Höhere Schmelztemperaturen führen zu reduzierter "droplet"-Bildung. Daher ist die Defektstellenkonzentration bei einer TiN-Beschichtung (Schmelzpunkt von Ti: 1670°C) wesentlich geringer als bei der TiAlN-Beschichtung (Schmelzpunkt für 50 : 50 TiAl: 1450°C).

Es wurden zwei Möglichkeiten aufgezeigt, diese Effekte zu reduzieren. Ersetzt man nämlich den Metall-Ionen-Ätz-Schritt mit TiAl durch einen Argon-Ätz-Prozeß, dann wird die Wachstumsdefektentwicklung nahezu vollständig unterdrückt.

Allerdings wurde auch festgestellt, daß die Haftfähigkeit von TiAlN-Schichten stark beeinträchtigt wird, wenn man den Metall-Ionen-Ätz-Schritt durch einen Ätzschritt mit inerten Ar-Ionen ersetzt.

Um den Einfluß des Targetmaterials bei der Kathoden-Bogenentladungsverdampfung auf die Entstehung von "droplets" und auf die Haftfähigkeit von TiAlN-Schichten zu verstehen, wurden die Metalle Al, TiAl, Ti, Zr, Cr, Nb, Mo als Metall-Ionen-Ätz-Dampf untersucht. Während dieser Ätzexperimente wurde das Substratmaterial aus Stahl an eine negative Vorspannung von - 1200 Volt gelegt. Während der kathodischen Bogenentladung herrschte ein Ar-Druck von 10⁻³ mbar. Der Abstand zwischen Testsubstrat und Bogenentladungsquelle betrug im Mittel circa 40 cm.

Mit zunehmender Schmelztemperatur sank der Durchmesser der "droplets" von maximal 15 µm für Al auf etwa maximal 1,5 µm für Nb.

Parallel sank die "droplet"-Konzentration von 8 x 10⁴ "droplets" pro cm² für Al auf 1 x 10⁴ "droplets" pro cm² für Nb.

Auch die Rauhigkeit des Stahlsubstrats nach dem Ätzen erniedrigte sich von Rₐ = 0,044 µm für Al auf Rₐ = 0,005 µm für Nb wesentlich.

Die genannten Metalle überstreichen einen Schmelzpunktbereich von circa 660°C für Al bis 2470°C für Nb.

Alle Materialien von TiAl (1450°C), Ti (1670°C), Zr (1850°C) bis Cr (1870°C) folgen hinsichtlich ihrer Neigung zur "droplet"-Bildung dieser Tendenz.

Nur im Falle des Chroms und des Molybdäns ist ein besonders niedriges Niveau der "droplet"-Bildung erreichbar.

Obwohl Cr im Schmelzpunkt nahe beim Zirkon liegt, besaß die Oberflächenrauhigkeit bereits den gleichen niedrigen Wert wie beim Metall Niob als kathodische Bogenentladungsquelle, nämlich Rₐ = 0,005 µm. Als Erklärung kann der hohe Dampfdruck des Chroms noch weit unter dem Schmelzpunkt angesehen werden. Selbst nach der Erstarrung verringert sich offensichtlich der Durchmesser der "droplets" am Substrat merklich.

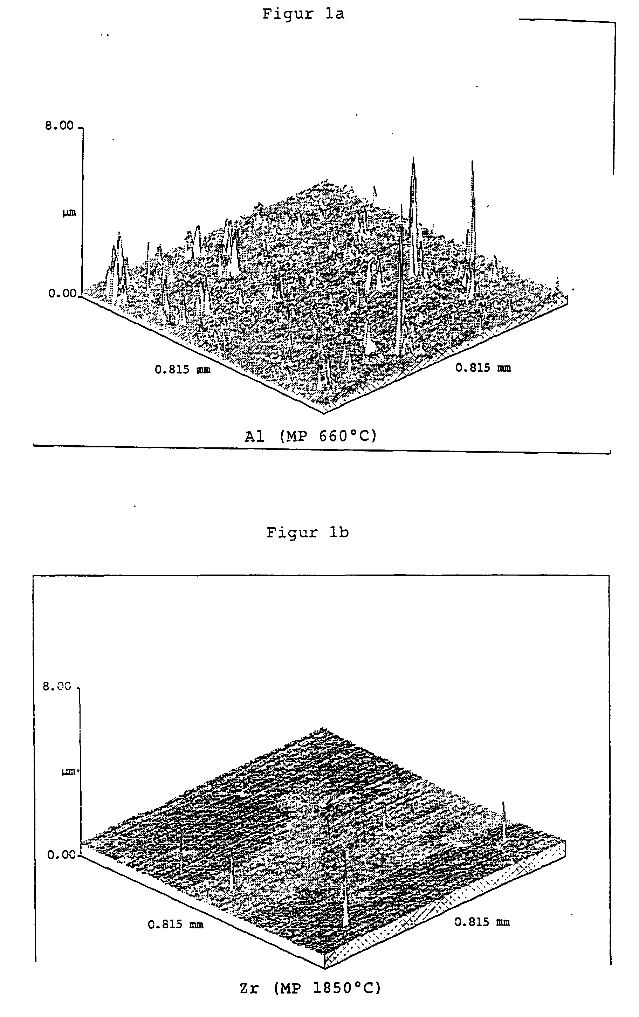

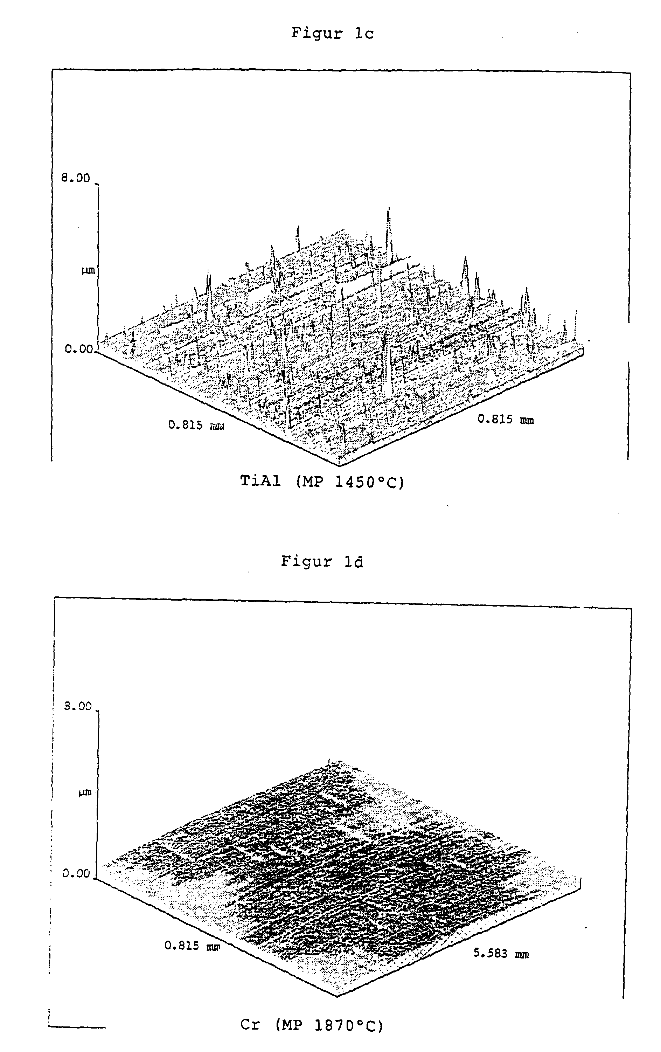

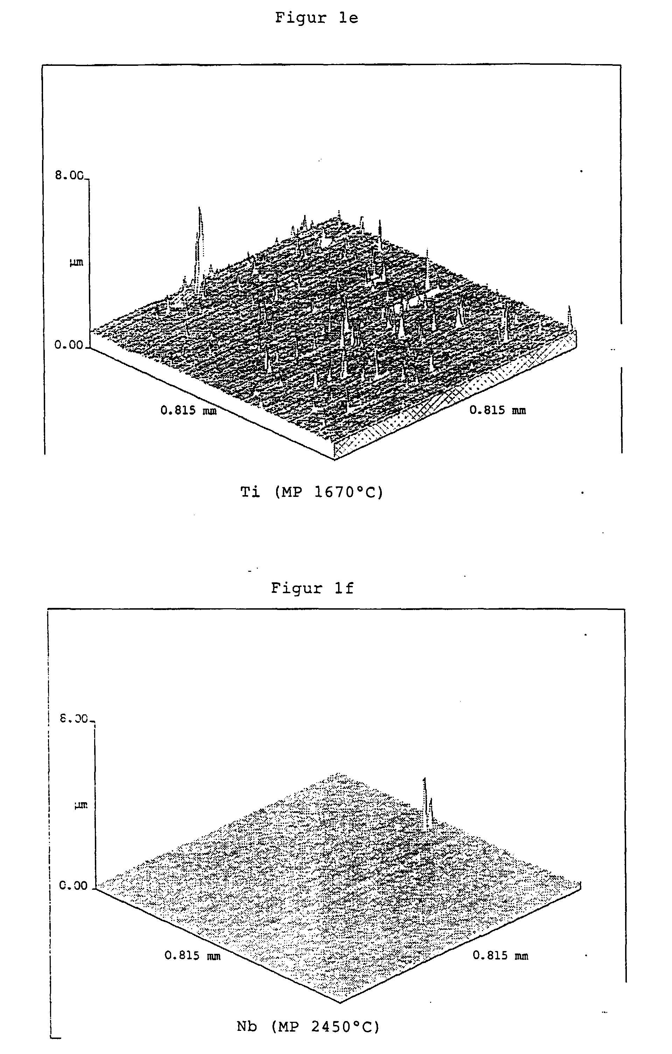

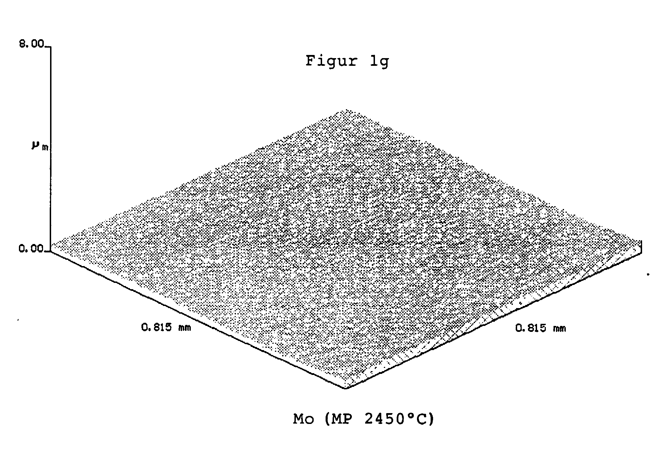

Zur Erläuterung dieses Sachverhalts zeigen die Figuren 1a bis 1g eine Serie von Oberflächenprofilen.

Die Peakhöhe ist proportional zum Durchmesser des "droplets" und entspricht für alle Materialien außer Al im Maximum 4 µm. Zu beachten ist dabei der um den Faktor 2 verkleinerte Maßstab beim Aluminium. Hier entspricht der Maximalwert etwa 8 µm.

Parallel wurde gefunden, daß die Haftfestigkeit von TiAlN-Schichten, abgeschieden mit dem unbalancierten Magnetron, auf Schnellarbeitsstahl HSS mit TiAl, Cr oder Ti im Metall-Ionen-Ätzprozeß praktisch vergleichbar hoch ist, nämlich: kritische Last 50 - 70 N, während bei Zr und Nb dieser charakteristische Wert auf 30 - 40 N absank.

Vergleicht man die Rauhigkeit von 3 bis 4 µm dicken TiAlN-Schichten auf Schnellarbeitsstahl HSS geätzt mit Cr-Ionen und solchen, die mit TiAl geätzt wurden, so findet man für Cr-geätzte Proben einen Wert von Rₐ = 0,05 µm und für mit TiAl geätzte Proben einen Wert von Rₐ = 0,15 µm.

Auf der Grundlage dieser positiven Ergebnisse auf ebenen, polierten Testsubtraten wurden Spiralbohrer mit einem Durchmesser von 8 mm untersucht, die nach dem ABS-Verfahren mit TiAlN circa 3 µm dick beschichtet wurden. Bei dem ABS-Verfahren handelt es sich um ein kombiniertes Metall-Ionen-Ätzen in kathodischer Bogenentladung und ein Beschichten mit dem unbalancierten Magnetron.

Folgende Schneidparameter wurden benutzt:

| | |
|---|---|
| Material | GG25 (Grauguß) |
| Schneidgeschwindigkeit | 60 m/min |
| Vorschub | 0,2 mm/Upm |
| Tiefe (Sackloch) | 28 mm |
| Schmiermittel | trocken |

Es wurden folgende Schneidergebnisse erhalten:

| | |
|---|---|
| Unbeschichtet | 20 Löcher |
| Beschichtet*/TiAl Ätzschritt | 100 Löcher |
| Beschichtet*/Cr Ätzschritt | 220 Löcher |

Die Zusammensetzung der Schicht beträgt 42 at% Ti und 58 at% Al auf 100 at% N.

Sämtliche Experimente wurden in einer 4-Target-Beschichtungsanlage vom Typ HTC-1000/4 ABS durchgeführt.

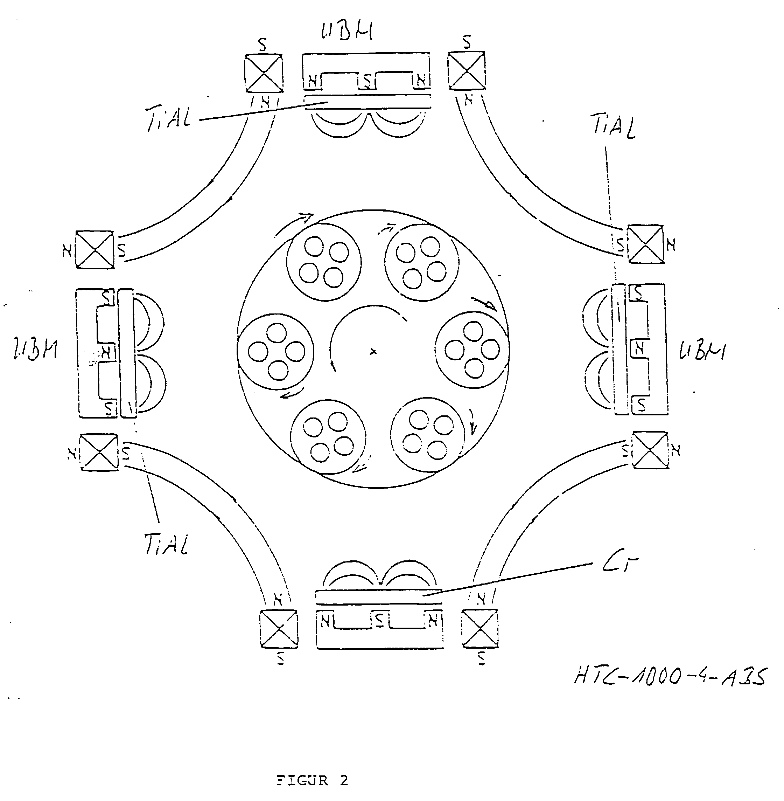

Figur 2 zeigt einen schematischen Querschnitt durch eine nach dem ABS-Verfahren erarbeitende Anlage HTC-1000/4 ABS. Vier vertikal angeordnete Kathoden (Targetfläche: 600 x 200 mm²) können entweder nach dem kathodischen Bogenentladungs-Verdampfungsprinzip oder als unbalanciertes Magnetron verwendet werden.

Alle vier Kathoden können mit Hilfe von Elektromagneten (konzentrische Spulen) magnetisch miteinander gekoppelt werden, so daß ein magnetisch geschlossener Raum entsteht, in dem sich die Substratträger befinden, welche sich drehen und zusätzlich auf einem Drehteller angeordnet sind. Der Übergang von kathodischer Bogenentladung zum unbalancierten Magnetron läßt sich über die Position der Permanentmagnete relativ zur Targetoberfläche einstellen. Während der durchgeführten Experimente wurden drei Kathoden mit TiAl (50 : 50) und eine Kathode mit Cr-Targets belegt.

Die angeführten Schneidergebnisse haben sich weiter verbessern lassen, wenn man in einer 4-fach-Target-PVD-Anlage das für den Ätzschritt benutzte Cr-Target auch während der TiAlN-Beschichtung benutzte. In diesem Falle konnte das Bohrergebnis auf 380 Löcher erhöht werden. Ähnlich positivere Werte, nämlich 420 Löcher, wurden erzielt, wenn man beim Cr-Target während der TiAlN-Beschichtung mit dem unbalancierten Magnetron zu den Prozeßgasen Ar und N kohlenstoffhaltige Gase wie CH₄ oder C₂H₂ usw. hinzufügte. Dabei wurde das kohlenstoffhaltige Gas nur während der letzten Phase der Beschichtung, zum Beispiel nach Ablauf von 75 % der Gesamtbeschichtungszeit, zum bereits vorhandenen Gasgemisch hinzugefügt.

Schließlich wurden vergleichende Bohrtests durchgeführt an Bohrern, die mit ABS bzw. in reiner kathodischer Bogenentladungsbedampfungstechnik beschichtet wurden.

Hier zeigte sich folgendes Ergebnis:
ABS mit TiAl in der Metall-Ionen-Ätzstufe und reine kathodische Bogenentladungsverdampfungsbeschichtung zeigten im oben beschriebenen Test ähnliche Ergebnisse, das heißt das Bohrergebnis lag bei circa 100 Löchern.

Damit ist der Nachweis erbracht, daß im Hinblick auf die Trockenzerspanung höchste Sorgfalt bezüglich der Schichtrauhigkeit entwickelt werden muß. Rauhe Schichten sind offenbar einem erhöhten Reibungswiderstand ausgesetzt. Damit entstehen erhöhte Schneidtemperaturen, was wiederum zu verkürzten Standzeiten führt. Die vorgelegten Ergebnisse zeigen deutlich, daß auf der Basis geeigneter Materialauswahl das Phänomen der "droplet"-Bildung maßgeblich beeinflußt werden kann.

Im folgenden Schema ist der Verfahrensablauf für die ABS-Beschichtung mit Cr oder TiAl als Metall-Ionen-Ätz-Variante dargestellt.

Beide Methoden führen zu sehr unterschiedlichen Ergebnissen im Hinblick auf die Rauhigkeit der Schichtoberflächen. Cr-geätzte Substrate sind wesentlich glatter als TiAl geätzte Substrate.

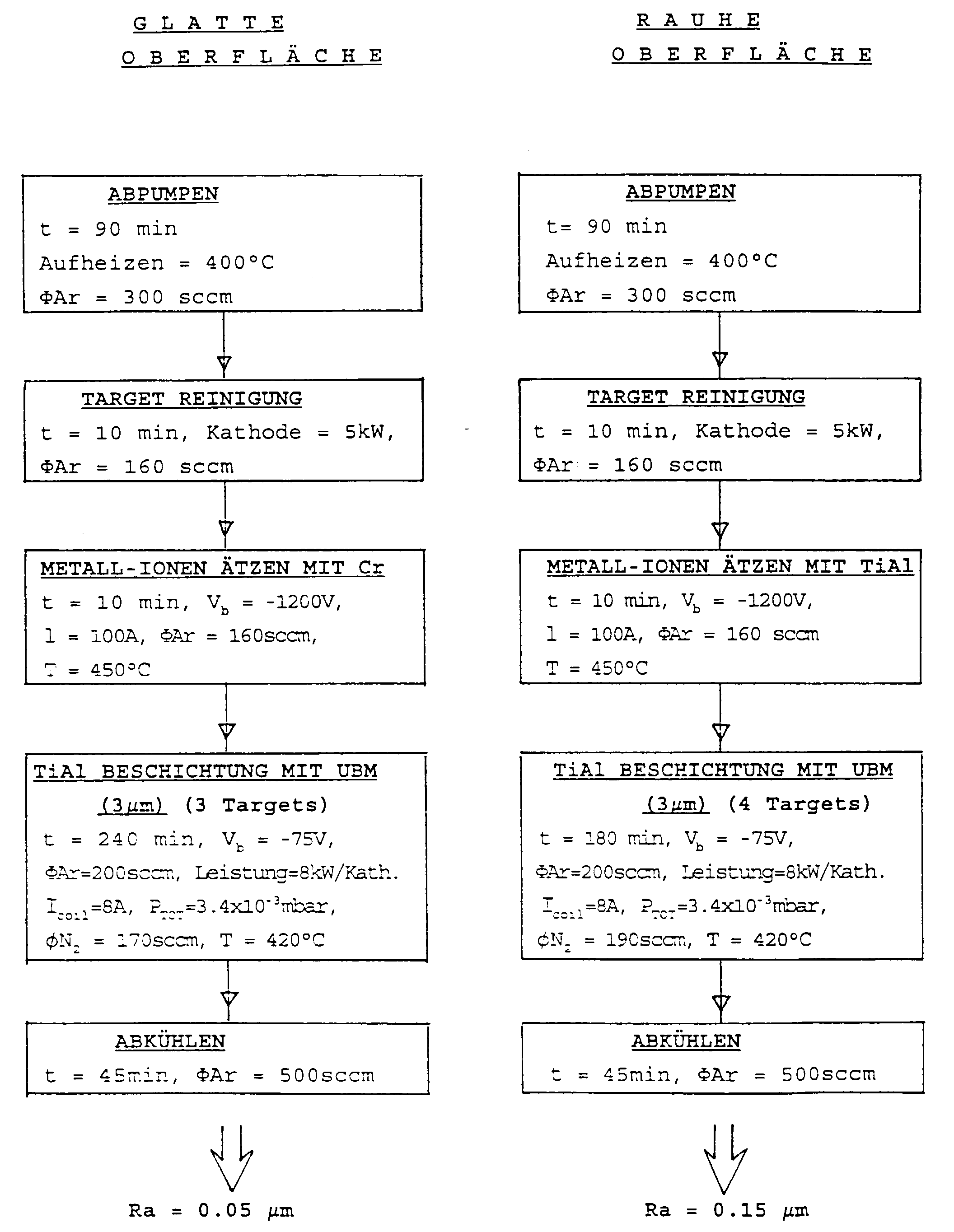

## Patentansprüche

1. Verfahren zum Beschichten von metallischen und keramischen Substraten, wie Schneidwerkzeugen, Umformwerkzeugen, Turbinenschaufeln und dergleichen mit TiAlN unter Benutzung von PVD-Beschichtungsmethoden, insbesondere dem unbalancierten Magnetron oder dem kathodischen Bogenentladungsverdampfungsverfahren,
dadurch **gekennzeichnet**,
daß vor der Beschichtung eine Ätz-Behandlung der Substratoberfläche mit Cr- und / oder Mo-Ionen stattfindet.

2. Verfahren nach Anspruch 1,
dadurch **gekennzeichnet**,
daß die Cr- und / oder Mo-Ionen aus einer kathodischen Bogenentladungsverdampfung stammen.

3. Verfahren nach Anspruch 1 oder 2,
dadurch **gekennzeichnet**,
daß die Substrate während der Metall-Ionen-Ätzbehandlung an einer negativen Vorspannung im Bereich von 800 bis 1200 Volt liegen und die negative Vorspannung bevorzugt 1200 Volt beträgt.

4. Verfahren nach einem der vorhergehenden Ansprüche,
dadurch **gekennzeichnet**,
daß die Substrate aus Schnell-, Kalt- oder Warmarbeitsstahl oder aus Wolframkarbid bestehen.

5. Verfahren nach einem der vorhergehenden Ansprüche,
dadurch **gekennzeichnet**,
daß die TiAlN Hartstoffschichten einen Metallanteil von 40 bis 85 at% Titan bzw. 15 bis 60 at% Aluminium aufweisen und bevorzugt der Titangehalt etwa 42 at% und der Aluminiumgehalt etwa 58 at% beträgt.

6. Verfahren nach einem der vorhergehenden Ansprüche,
dadurch **gekennzeichnet**,
daß während der Beschichtung der Substrate mit TiAlN zusätzlich und simultan Cr bzw. CrN entweder mit dem unbalancierten Magnetron oder mit dem kathodischen Bogenentladungsverdampfungsverfahren abgeschieden wird.

7. Verfahren nach Anspruch 6,
dadurch **gekennzeichnet**,
daß der Anteil an Cr am Gesamtmetallgehalt der TiAlCrN-Schicht zwischen 5 und 60 at% liegt und vorzugsweise der Anteil an Cr am Gesamtmetallgehalt 20 at% beträgt und der Anteil von Ti 34 at% und der Anteil von Al 46 at% umfaßt.

8. Verfahren nach Anspruch 6 oder 7,
dadurch **gekennzeichnet**,
daß der an das Substrat angrenzende Schichtteil aus reinem TiAlN und nur der darauffolgende Schichtanteil aus TiAlCrN besteht.

9. Verfahren nach Anspruch 8,
dadurch **gekennzeichnet**,
daß die Basisschicht aus TiAlN bis 30 % der Gesamtschichtdicke beträgt.

10. Verfahren nach einem der vorhergehenden Ansprüche,
dadurch **gekennzeichnet**,
daß mindestens 75 % der Beschichtung mit TiAl reaktiv in einer Gasatmosphäre bestehend aus Ar und N₂ stattfindet und daß der Rest der Beschichtung in einem Gemisch aus Ar und N₂ bzw. aus einem Kohlenwasserstoffgas, zum Beispiel CH₄, C₂H₂ und dergleichen abläuft.

11. Verfahren nach einem der vorhergehenden Ansprüche,
dadurch **gekennzeichnet**,
daß mindestens 75 % der Beschichtung mit TiAlCr reaktiv in einer Gasatmosphäre bestehend aus Ar und N₂ stattfindet und daß der Rest der Beschichtung in einem Gasgemisch aus Ar und N₂ bzw. aus einem Kohlenwasserstoffgas, zum Beispiel wie CH₄, C₂H₆, C₂H₂ und dergleichen abläuft.

12. Verfahren nach einem der vorhergehenden Ansprüche,
dadurch **gekennzeichnet**,
daß eine 0,05 bis 1 µm dicke Schicht aus MoS₂ auf die Oberfläche der TiAlN, TiAlCrN, TiAlCN oder TiAlCrCN Schicht abgeschieden wird.

13. Verfahren nach Anspruch 12,
dadurch **gekennzeichnet**,
daß der Übergang zwischen Nitrid- oder Carbonnitridschicht in die Sulfidschicht verlaufend stattfindet, das heißt daß eine Verzahnung von Nitrid und Sulfid herbeigeführt wird.

## Claims

1. Method of coating metallic and ceramic substrates such as cutting tools, forming tools, turbine blades and the like with TiAlN using PVD-coating methods, in particular using the imbalanced magnetron or the cathodic arc discharge vaporization process, characterised in that an etch treatment of the substrate surface takes place with Cr- and/or Mo ions prior to the coating.

2. Method in accordance with claim 1, characterised in that the Cr- and/or Mo ions originate from a cathodic arc discharge vaporisation process.

3. Method in accordance with claim 1 or claim 2, characterised in that during the metal ion etch treatment the substrate lies at a negative bias voltage in the range from 800 to 1200 volts and the negative bias voltage preferably amounts to 1200 volts.

4. Method in accordance with one of the preceding claims, characterised in that the substrate consists of high speed steel, cold working steel, hot working steel or of tungsten carbide.

5. Method in accordance with one of the preceding claims, characterised in that the TiAlN hard metal layers have a metal content of 40 to 85 atomic % titanium and 15 to 60 atomic % aluminum respectively and in that the titanium content preferably amounts to approximately 42 atomic % and the aluminum content to approximately 58 atomic %.

6. Method in accordance with one of the preceding claims, characterised in that during the coating of the substrate with TiAlN, Cr or CrN is additionally and simultaneously deposited either with the imbalanced magnetron method or with the cathodic arc discharge vaporization method.

7. Method in accordance with claim 6, characterised in that the proportion of Cr in the total metal content of the TiAlCrN layer lies between 5 and 60 atomic % and the proportion of Cr in the total metal content preferably amounts to 20 atomic % and the proportion of Ti to 34 atomic % and the proportion of Al to 46 atomic %.

8. Method in accordance with claim 6 or claim 7, characterised in that the portion of the layer adjoining the substrate consists of pure TiAlN and only the following portion of the layer consists of TiAlCrN.

9. Method in accordance with claim 8, characterised in that the base layer of TiAlN amounts to up to 30 % of the total layer thickness.

10. Method in accordance with one of the preceding claims, characterised in that at least 75 % of the coating with TiAl takes place reactively in the gas atmosphere consisting of Ar and N₂, and in that the remainder of the coating takes place in a mixture of Ar and N₂ or of a hydrocarbon gas, for example CH₄, C₂H₂ and the like.

11. Method in accordance with one of the preceding claims, characterised in that at least 75 % of the coating with TiAlCr takes place reactively in a gas atmosphere consisting of Ar and N₂, and in that the remainder of the coating takes place in a gas mixture of Ar and N₂ or of a hydrocarbon gas, for example such as CH₄, C₂H₆, C₂H₂ and the like.

12. Method in accordance with one of the preceding claims, characterised in that a 0.05 to 1 µm thick layer of MoS₂ is deposited onto the surface of the TiAlN, TiAlCrN, TiAlCN or TiAlCrCN layer.

13. Method in accordance with claim 12, characterised in that the transition between the nitride layer or the carbon nitride layer into the sulfide layer takes place continuously, that is to say an intermeshing of nitride and sulfide is carried out.

## Revendications

1. Procédé de revêtement de substrats métalliques et céramiques, tels qu'outils de coupe, outils de formage, pales de turbines et analogues, par du TiAlN en utilisant des procédés de revêtement par dépôt physique en phase vapeur, notamment le magnétron non équilibré ou le procédé de pulvérisation cathodique à décharge d'arc,
caractérisé en ce que, préalablement au revêtement, un traitement d'attaque de la surface des substrats est effectué par des ions de Cr et/ou de Mo.

2. Procédé selon la revendication 1,
caractérisé en ce que les ions de Cr et/ou de Mo proviennent d'une pulvérisation cathodique à décharge d'arc.

3. Procédé selon la revendication 1 ou 2,
caractérisé en ce que les substrats sont soumis, pendant le traitement d'attaque par ions métalliques, à une tension de polarisation négative comprise dans la plage de 800 à 1 200 V, cette tension de polarisation négative étant, de préférence, de 1 200 V.

4. Procédé selon l'une des revendications précédentes,
caractérisé en ce que les substrats consistent en un acier rapide, en un acier pour travail à froid ou à chaud, ou en du carbure de tungstène.

5. Procédé selon l'une des revendications précédentes,
caractérisé en ce que les couches dures de TiAlN présentent une teneur de 40 à 85 % en poids atomique de titane et de 15 à 60 % en poids atomique d'aluminium, la teneur en titane étant, de préférence, d'environ 42 % en poids atomique et la teneur en aluminium d'environ 58 % en poids atomique.

6. Procédé selon l'une des revendications précédentes,
caractérisé en ce que, pendant le revêtement des substrats par le TiAlN, du Cr ou bien du CrN est en plus et simultanément déposé, soit par le magnétron non équilibré soit par le procédé de pulvérisation cathodique à décharge d'arc.

7. Procédé selon la revendication 6,
caractérisé en ce que la fraction représentée par le Cr dans la composition métallique totale de la couche de TiAlCrN est comprise dans la fourchette de 5 à 60 % en poids atomique et, de préférence, cette teneur en Cr représentant 20 % en poids atomique, la teneur en Ti étant de 34 % en poids atomique et la teneur en Al étant de 46 % en poids atomique.

8. Procédé selon la revendication 6 ou 7,
caractérisé en ce que la partie de la couche, limitrophe du substrat, consiste en du TiAlN pur et en ce que seule la partie de couche suivante consiste en du TiAlCrN.

9. Procédé selon la revendication 8,
caractérisé en ce que la couche de base en TiAlN représente jusqu'à 30 % de l'épaisseur totale de la couche.

10. Procédé selon l'une des revendications précédentes,
caractérisé en ce qu'au moins 75 % du revêtement par le TiAl est effectué, de manière réactive dans une atmosphère gazeuse consistant en de l'Ar et du N₂, et en ce que le reste du revêtement se déroule dans un mélange d'Ar et de N₂ ou bien d'un hydrocarbure, par exemple du CH₄, du C₂H₂ et analogues.

11. Procédé selon l'une des revendications précédentes,
caractérisé en ce qu'au moins 75 % du revêtement par le TiAlCr est effectué, de manière réactive, dans une atmosphère gazeuse consistant en de l'Ar et du N₂, et en ce que le reste du revêtement se déroule dans un mélange gazeux d'Ar et de N₂ ou bien d'un hydrocarbure, par exemple du CH₄, du C₂H₆, du C₂H₂ et analogues.

12. Procédé selon l'une des revendications précédentes,
caractérisé en ce qu'une couche de MoS₂ est déposée en une épaisseur de 0,05 à 1 µm sur la surface de la couche de TiAlN, de TiAlCrN, de TiAlCN ou de TiAlCrCN.

13. Procédé selon la revendication 12,
caractérisé en ce que la transition entre la couche de nitrure ou la couche de nitrure de carbone et la couche de sulfure se produit de manière continue, c'est-à-dire qu'elle aboutit à une imbrication du nitrure et du sulfure.
